# EUROPEAN PATENT APPLICATION

(11) **EP 4 651 211 A1**
(43) Date of publication of application: **19.11.2025**
(21) Application number: 23916430.4
(22) Date of filing: 14.12.2023
(51) Int. Cl.: H01L 31/18, H01L 31/05

(54) **SOLAR CELL MANUFACTURING APPARATUS AND SOLAR CELL MANUFACTURING METHOD**

(30) Priority: 12.01.2023 KR 20230004921
(71) Applicant: Hanwha Solutions Corporation, Seoul 04541 (KR)
(72) Inventor: JUNG, Min Kyo, Seoul 04541 (KR); BAEK, Dong Heon, Seoul 04541 (KR)
(74) Representative: Mooser, Sebastian Thomas
(86) International application number: PCT/KR2023/020673
(87) International publication number: WO 2024/150947

(57) **Abstract**

A solar cell manufacturing apparatus according to an embodiment of the present invention comprises: a first dispenser for applying a conductive adhesive to a first side of a solar cell; a flip portion that turns the solar cell over; a second dispenser for applying a conductive adhesive to a second side of the solar cell; a first conveyor that transports the solar cell, the first side of which is applied through the first dispenser, to a location where the flip portion is located; and a shuttle that transports the solar cell turned over through the flip portion, to a location where the second dispenser is located.

## Description

### [Technical Field]

Embodiments of the present invention relate to a solar cell manufacturing apparatus and a solar cell manufacturing method.

### [Background Art]

A solar cell, that is, a solar battery is formed by arranging a p-n junction diode on a substrate. When a solar cell is irradiated with sunlight, an exciton, which is an electron-hole pair, is generated, and as the exciton separates, the electron moves to an n layer and the hole moves to a p layer, and thus photovoltaic power is generated at a p-n junction. Tabbing is a process of forming one solar cell module by disposing wires on multiple solar cells and electrically connecting multiple solar cells.

In this case, as a process of bonding the solar cell and the wire, there is a process of applying an electrically conductive adhesive (ECA) to a surface of the solar cell and then bonding the wire and the solar cell.

In the case of the process of bonding solar cells and wires using conductive adhesives, various studies are being conducted on specific examples as a next-generation solar cell manufacturing process.

### [Disclosure]

### [Technical Problem]

The problem to be solved by the present invention is to provide a solar cell manufacturing apparatus and a solar cell manufacturing method including a process of bonding a solar cell and a wire using a conductive adhesive.

However, the above problem is exemplary, and the problems to be solved by the present invention are not limited thereto.

### [Technical Solution]

A solar cell manufacturing apparatus according to one embodiment of the present invention includes a first dispenser configured to apply a conductive adhesive to a first surface of a solar cell, a flip part configured to flip the solar cell, a second dispenser configured to apply a conductive adhesive to a second surface of the solar cell, a first conveyor configured to transfer the solar cell with the first surface to which the conductive adhesive is applied through the first dispenser to a place where the flip part is located, and a shuttle configured to transfer the solar cell flipped through the flip part to a place where the second dispenser is located.

The flip part may include: a rotating main body part; and a first flip part coupled to one side of the main body part, and the first flip part may include: a first suction part configured to suction the solar cell in a direction in which the flip part is located, and a first protrusion having an end portion protruding to come into contact with the solar cell.

The first flip part may be coupled to the second surface of the solar cell through the first protrusion and the first suction part, and when the main body part is rotated, the first flip part may be released from the coupling with the solar cell and the solar cell may be seated on the shuttle.

The shuttle may include a shuttle protrusion formed to protrude upward so that the solar cell is seated.

The shuttle may include first and second portions on which both sides and a center side of the solar cell are respectively seated, and the shuttle protrusions may be disposed in the first and second portions, respectively.

The solar cell manufacturing apparatus may further include a heat treatment zone in which the solar cell passing through the second dispenser is bonded to a wire.

A plurality of first protrusions may be formed to come into contact with a plurality of portions of the solar cell.

The first dispenser may apply the conductive adhesive to the first surface of the solar cell disposed below the first dispenser, and the second dispenser may apply the conductive adhesive to the second surface of the solar cell disposed below the second dispenser.

At least one first flip part may be formed.

The first flip parts may be formed on both sides with the main body part as the center, and as the main body part rotates, the two first flip parts may alternately flip the solar cell.

A solar cell manufacturing method includes: an operation of transferring a solar cell to a place where a first dispenser is located; an operation of applying a conductive adhesive to a first surface of the solar cell through the first dispenser; an operation of transferring the solar cell including the first surface to which the conductive adhesive is applied to a flip part through a first conveyor; an operation of flipping, by the flip part, the solar cell; an operation of seating the flipped solar cell on a shuttle; an operation of transferring, by the shuttle, the solar cell to a place where a second dispenser is located; and an operation of applying, by the second dispenser, a conductive adhesive to a second surface of the solar cell.

The operation of seating the flipped solar cell on the shuttle may include: an operation of moving the shuttle upward; an operation of seating the solar cell on the shuttle; and an operation of moving the shuttle downward.

The solar cell manufacturing method may further include an operation of performing a wire bonding process by moving the solar cell to which the conductive adhesive is applied on both the first and second surfaces to a heat treatment zone.

Other aspects, features, and advantages other than those described above will become clear from the detailed description, claims, and drawings for implementing the following invention.

### [Advantageous Effects]

In a solar cell manufacturing apparatus and a solar cell manufacturing method according to one embodiment of the present invention, both the front and back of a solar cell can be applied through a dispenser and a flip part that flips the solar cell.

In addition, in a solar cell manufacturing apparatus and a solar cell manufacturing method according to one embodiment of the present invention, both first and second dispensers can apply the solar cell from the top to the bottom without the need to apply the solar cell from top to bottom to apply both surfaces of the solar cell, and thus the conditions of two dispensers can be configured to be the same when applying two surfaces of the solar cell. Accordingly, an application device is simplified, and two dispensers can be formed to the same specification, thereby enabling the two dispensers to be interchangeably replaced to improve convenience.

In addition, in a solar cell manufacturing apparatus and a solar cell manufacturing method according to one embodiment of the present invention, a shuttle protrusion is formed to minimize contact with a conductive adhesive already applied to a first surface when a second surface of the solar cell is applied. By applying the shuttle protrusion as a new member, a surface portion of the solar cell can be protected and tearing and peeling of the surface material of the solar cell can be prevented.

In addition, in a solar cell manufacturing apparatus and a solar cell manufacturing method according to one embodiment of the present invention, a surface portion of the solar cell can be protected by applying a protrusion end portion member coming into contact with the surface of the solar cell as a new member and tearing and peeling of the surface material of the solar cell can be prevented.

In addition, in a solar cell manufacturing apparatus and a solar cell manufacturing method according to one embodiment of the present invention, a tac time can be reduced by newly configuring a heat treatment zone coupling a wire and the applied solar cell after the front and rear surface of the solar cell are applied.

The effects of the present invention are not limited to above-mentioned effects, and other effects not mentioned will be apparent to those skilled in the art from the description of the claims.

### [Description of Drawings]

FIG. 1 is a top view of a solar cell manufacturing apparatus according to one embodiment of the present invention.
FIG. 2 is a side view of the solar cell manufacturing apparatus according to one embodiment of the present invention.
FIG. 3 is a side view illustrating a configuration of a peripheral part of a flip part of the solar cell manufacturing apparatus according to one embodiment of the present invention in more detail.
FIG. 4 is a view illustrating a configuration of a first suction part and a first protrusion of the first flip part according to one embodiment of the present invention.
FIG. 5 is a top view illustrating the flip part and a peripheral configuration thereof according to one embodiment of the present invention in more detail.
FIG. 6 is a top view of a shuttle according to one embodiment of the present invention.
FIG. 7 is a view illustrating operations (FIG. 7A, FIG. 7B, and FIG. 7C) in which the shuttle receives and transfers a solar cell.

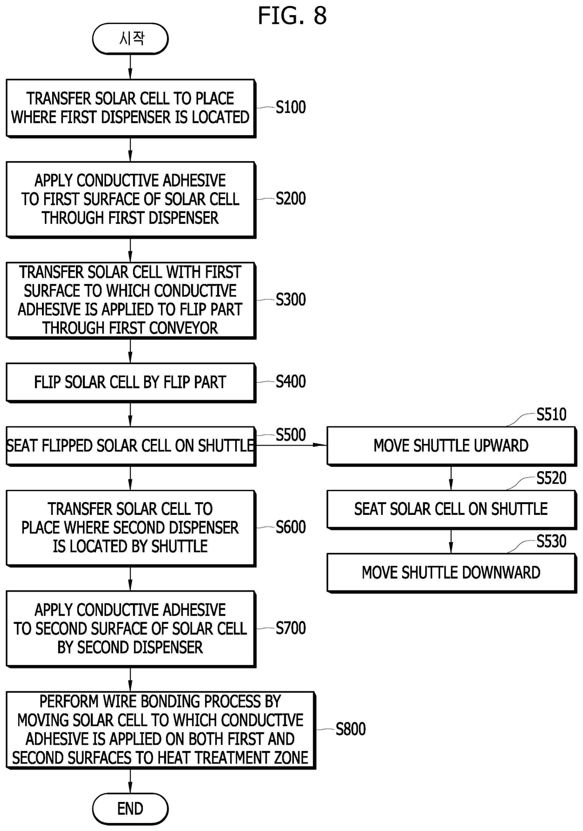

FIG. 8 is a flowchart illustrating a solar cell manufacturing method according to one embodiment of the present invention.

### [Modes of the Invention]

Since the present invention may be modified in various ways and may have various embodiments, specific embodiments will be illustrated in the drawings and described in detail in the description of the invention. However, this is not intended to limit the present invention to specific embodiments, and it should be understood that the present invention includes all modifications, equivalents, and substitutes included in the spirit and technical scope of the present invention. In describing the present invention, the same identification numbers are used for the same components even though they are illustrated in other embodiments.

Hereinafter, embodiments of the present invention will be described in detail with reference to the accompanying drawings, and the same or corresponding components will be assigned the same reference numerals when described with reference to the drawings, and redundant descriptions thereof will be omitted.

In the following embodiments, terms such as first, second, and the like are used for the purpose of distinguishing one component from another component, rather than having a limited meaning.

In the following embodiments, a singular expression includes a plural expression unless the context clearly indicates otherwise.

In the following embodiment, terms such as include or comprise refer to the presence of features or components described in the specification, and do not preclude the possibility of adding one or more other features or components.

In the drawings, for convenience of description, the sizes of the components may be exaggerated or reduced. For example, the size and thickness of each component illustrated in the drawings are arbitrarily shown for convenience of description, and thus the present invention is not necessarily limited to what is illustrated in the drawings.

When an embodiment can be implemented differently, a specific process order may be performed differently from the order described. For example, two processes described in succession may be performed substantially simultaneously, or may be performed in the opposite order to the described order.

The terms used in the present application are used only to describe specific embodiments and are not intended to limit the present invention. In the present application, terms such as "include" or "comprise" are intended to designate the presence of features, numbers, steps, operations, components, parts, or combinations thereof described in the specification, and it should be understood that the possibility of the presence or addition of one or more other features, numbers, steps, operations, components, parts, or combinations thereof is not excluded in advance.

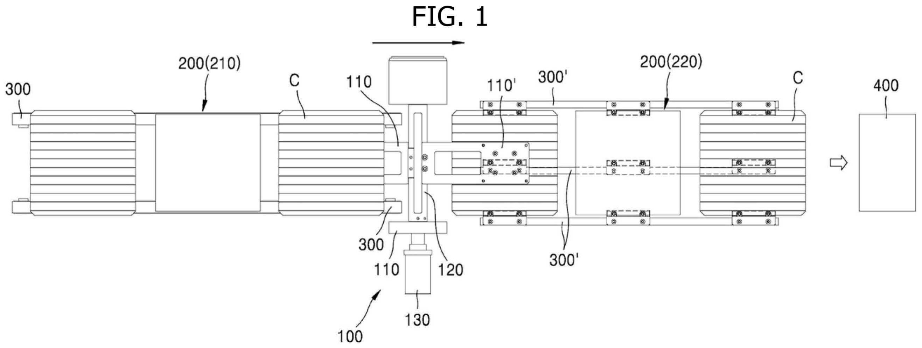

Hereinafter, a solar cell manufacturing apparatus according to one embodiment of the present invention will be described with reference to FIGS. 1 to 7.

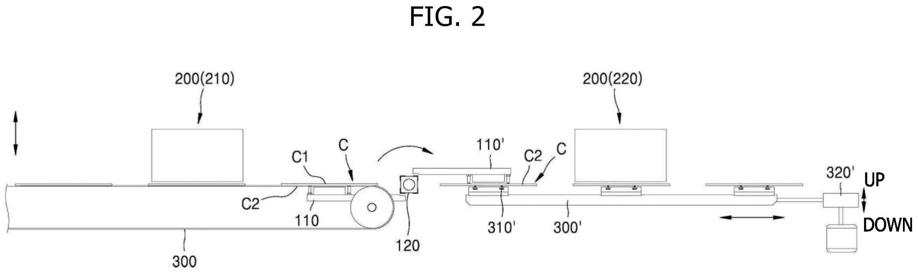

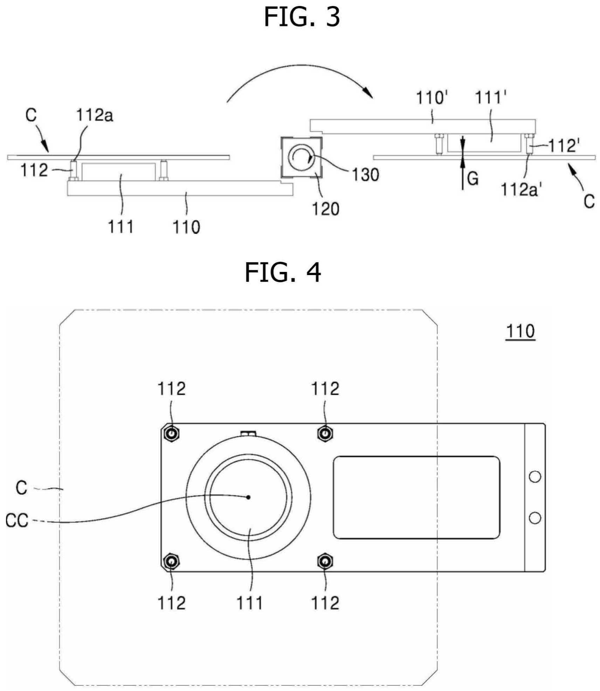

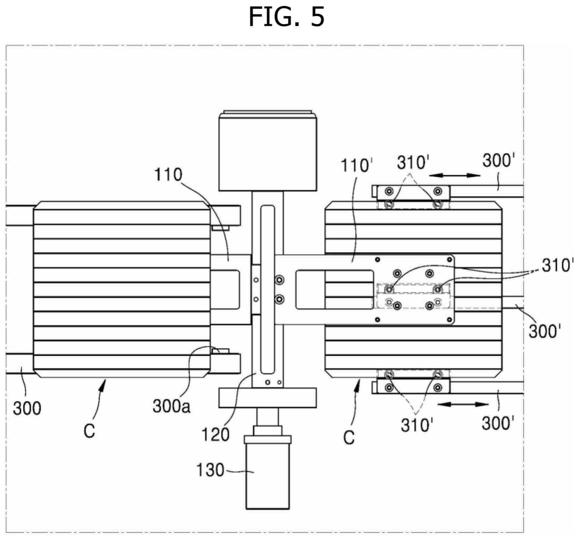

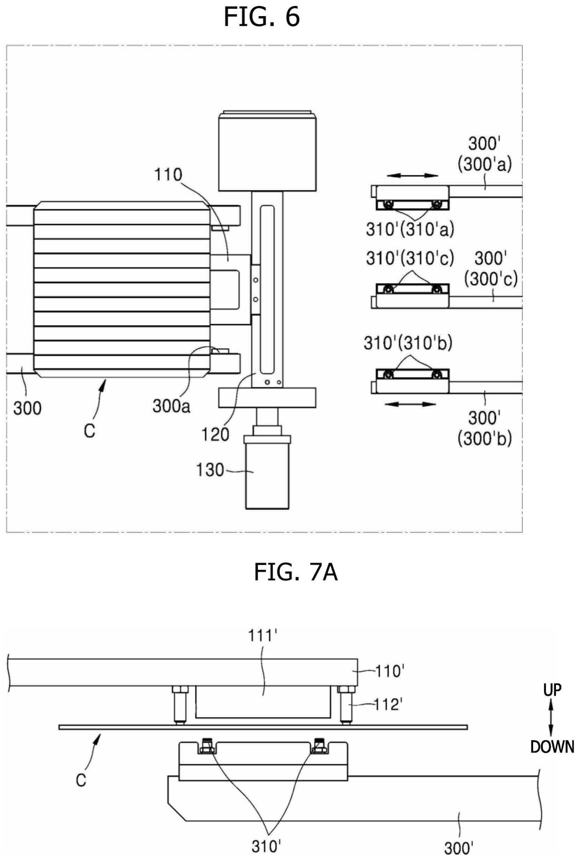

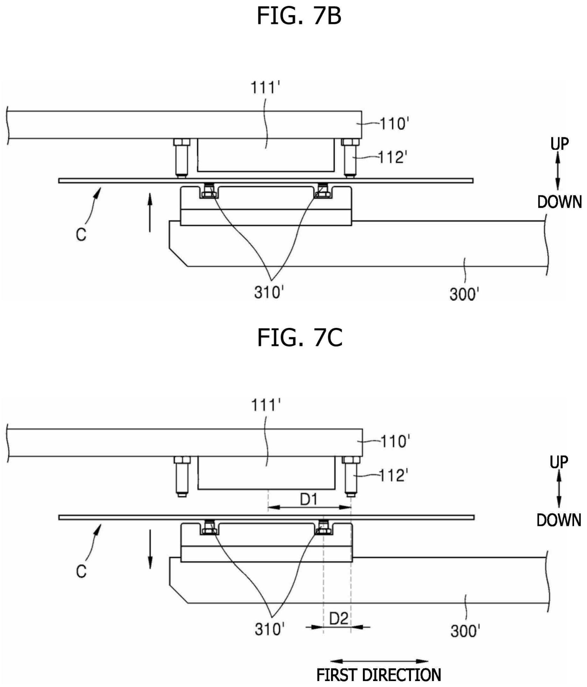

FIG. 1 is a top view of a solar cell manufacturing apparatus according to one embodiment of the present invention. FIG. 2 is a side view of the solar cell manufacturing apparatus according to one embodiment of the present invention. FIG. 3 is a side view illustrating a configuration of a peripheral part of a flip part of the solar cell manufacturing apparatus according to one embodiment of the present invention in more detail. FIG. 4 is a view illustrating a configuration of a first suction part and a first protrusion of the first flip part according to one embodiment of the present invention. FIG. 5 is a top view illustrating the flip part and a peripheral configuration thereof according to one embodiment of the present invention in more detail. FIG. 6 is a top view of a shuttle according to one embodiment of the present invention. FIG. 7 is a view illustrating operations (FIG. 7A, FIG. 7B, and FIG. 7C) in which the shuttle receives and transfers a solar cell.

Referring to FIGS. 1 to 7, the solar cell manufacturing apparatus according to one embodiment of the present invention includes a first dispenser 210 applying a conductive adhesive to a first surface C1 of a solar cell C, a flip part 100 flipping the solar cell C, and a second dispenser 220 applying a conductive adhesive to a second surface C2 of the solar cell C. In this case, the solar cell manufacturing apparatus includes a first conveyor 300 transferring the solar cell C with the first surface C1 to which the conductive adhesive is applied through the first dispenser 210 to a place where the flip part 100 is located, and a shuttle 300' transferring the solar cell C flipped through the flip part 100 to a place where the second dispenser 220 is located.

According to the present embodiment, the flip part 100 includes a rotating main body part 120 and a first flip part 110 coupled to one side of the main body part 120, and the first flip part 110 includes a first protrusion 112 with an end portion 112a protruding to come into contact with the solar cell and a first suction part 111 suctioning the solar cell C in a direction in which the flip part is located.

The solar cell C may be transferred to a place where the first dispenser 210 is located through the first conveyor 300, specifically, a space below the first dispenser 210. In this case, the transferred solar cell C may be in a state in which the first surface C1 faces upward. The solar cell C transferred to the space below the first dispenser 210 through the first conveyor 300 may have the first surface C1 to which the conductive adhesive is applied by the first dispenser 210. In this case, the first dispenser 210 may perform an application process on the solar cell C located in the space therebelow in the direction of gravity.

The solar cell C on which the application to the first surface C1 is completed may be transferred again to the place where the flip part 100 is located through the first conveyor 300. In this case, the first flip part 110 of the flip part 100 may be disposed in the space below the solar cell C. The first flip part 110 may have the first suction part 111 and the first protrusion 112 protruding from the space below the solar cell C to the second surface C2 of the solar cell C.

The first suction part 111 may suction the solar cell C in a direction in which the first flip part 110 is located. The first suction part 111 may be spaced apart from the solar cell C. In addition, the first protrusion 112 may be formed to protrude so that the end portion 112a thereof comes into contact with the solar cell. Accordingly, when the first suction part 111 suctions a part of the second surface C2 of the solar cell C, the second surface C2 of the solar cell C may be spaced apart from the first suction part 111 and may come into contact with the first protrusion 112. Therefore, the contact area between the flip part 100 and the solar cell C may be minimized, and the first protrusion 112 and the second surface C2 of the solar cell C may come into contact with each other by the suction force of the first suction part 111 to maintain a coupled state.

For example, the first suction part 111 may adsorb the solar cell C in a non-contact state using the Bernoulli effect. In detail, the flip part 100 may discharge compressed air to an edge region of the first suction part 111 to form a vacuum between the first suction part 111 and the second surface C2 of the solar cell C and may adsorb the solar cell C in a non-contact manner by negative pressure due to a pressure difference. To this end, the first suction part 111 may include a flow part (not shown) providing compressed air toward the solar cell C, and a guide part (not shown) discharging the compressed air toward a lower edge region of the first suction unit 111 facing the solar cell C at an end of the flow part.

After coupling between the first flip part 110 and the solar cell C is achieved, the flip part 100 may be rotated. In this case, the first flip part 110 may be rotated around the main body part 120 of the flip part 100 together with the suction-coupled solar cell C. The rotation may be performed at an angle of 180 degrees.

After the rotation of the flip part 100 is completed, the solar cell C may be positioned on a lower side of a first flip part 110'. In this case, an upper surface of the solar cell C may become the second surface C2, and a lower surface of the solar cell C may become the first surface C1.

After the rotation of the flip part 100 is completed, the first flip part 110' may release the coupling with the solar cell C. In this case, when the driving of the first suction part 111' is stopped, the contact coupling between a first protrusion part 112' and the solar cell C may be naturally released.

At the same time, the solar cell C may be seated on the shuttle 300'. According to the present embodiment, the shuttle 300' may include a shuttle protrusion 310' formed to protrude upward so that the solar cell C is seated.

The shuttle protrusion 310' may come into contact with a surface portion of the solar cell C between the conductive adhesive application portions on the surface of the solar cell C. Accordingly, the shuttle protrusion 310' may support both sides of the solar cell C and may safely transfer the solar cell C to a place where the second dispenser 220 is located.

In the solar cell C flipped through the flip part 100, the first surface C1 faces downward in a state in which the conductive adhesive is applied. In this case, the first surface C1 has no choice but to come into contact with the shuttle protrusion 310'. Accordingly, as in the present embodiment, by minimizing the contact area between the shuttle protrusion 310' and the first surface C1 to which the conductive adhesive is applied, damage to the surface portion of the solar cell to which the conductive adhesive is applied may be minimized.

According to the present embodiment, referring to FIG. 6, the shuttle 300' includes first and second portions 300'a and 300'b on which both sides of the solar cell C are respectively seated. For example, in addition to the first and second portions 300'a and 300'b, a third portion 300'c on which a center side of the solar cell C is seated may be further included. In this case, shuttle protrusions 310'a, 310'b, and 310'c may be disposed in the first, second, and third portions, respectively. In this case, two shuttle protrusions 310'a, 310'b, and 310'c may be symmetrically disposed in the first, second, and third portions, respectively.

In this way, by enabling the shuttle protrusion 310' to support the two sides and the center side of the solar cell C through the first, second, and third portions supporting the solar cell C, respectively, the solar cell C seated on the shuttle 300' may be stably transferred to the place where the second dispenser 220 is located. In this case, the shuttle protrusion 310' is formed as a new member, so that when the shuttle protrusion 310' comes into contact with the surface of the solar cell C, peeling, tearing, etc. (e.g., perovskite tearing) of the surface material of the solar cell C may be prevented, thereby improving a defect rate.

Also, referring to FIG. 7C, the shuttle protrusion 310' may be disposed at a set position. A transfer direction of the shuttle 300' may be defined as a first direction. In addition, a distance between the centers of the first protrusion 112' and the first suction part 111' based on the first direction may be defined as a first distance D1, and the distance between the first protrusion 112' and the shuttle protrusion 310' may be defined as a second distance D2.

In this case, the second distance D2 may be equal to or less than 30% of the first distance D1. Specifically, when the first flip part 110' transfers the solar cell C onto the shuttle 300', the first protrusion 112' may be disposed at an adjacent position satisfying the above-described range to minimize the stress applied to the solar cell C. Preferably, the shuttle protrusion 310' may be disposed at a position overlapping the first protrusion 112' in a vertical direction.

According to the present embodiment, since the first dispenser 210 applies the conductive adhesive to the first surface C1 of the solar cell C disposed below the first dispenser 210, and the second dispenser 220 applies the conductive adhesive to the second surface C2 of the solar cell C disposed below the second dispenser 220, a dispensing structure does not need to be disposed in the space below the solar cell C in order to apply the conductive adhesive to both surfaces of the solar cell C, so that the two dispensers 210 and 220 may apply the conductive adhesive to both sides of the solar cell C under the same conditions.

The shuttle protrusion 310' of the shuttle 300' may transfer the solar cell C to the place where the second dispenser 220 is located, specifically, to the space below the second dispenser 220. In this case, the transferred solar cell C may be in a state in which the second surface C2 faces upward. The solar cell C transferred to the space below the second dispenser 220 through the shuttle protrusion 310' may have the second surface C2 to which the conductive adhesive is applied by the second dispenser 220. In this case, the second dispenser 220 may perform an application process on the solar cell C located therebelow in the direction of gravity.

Referring to FIG. 6, when the solar cell C flipped by the flip part is seated 100, the shuttle protrusion 310' may move upward in the direction in which the flipped solar cell C is located (see FIG. 6B). Accordingly, an impact that may be applied when the solar cell C is seated on the shuttle protrusion 310' may be minimized, and the solar cell C may be stably seated on the shuttle protrusion 310'.

After the solar cell C is seated on the shuttle protrusion 310', the shuttle 300' may move downward again (see FIG. 6C). Accordingly, a height of the second dispenser 220 and the solar cell C seated on the shuttle protrusion 310' may be matched. The vertical movement of the shuttle 300' may be performed by a shuttle vertical movement part 320'.

According to the present embodiment, the solar cell C passing through the second dispenser 220 may be transferred to a heat treatment zone 400 to be bonded to a wire. The heat treatment zone 400 may maximize adhesion by drying the applied electrically conductive adhesive (ECA) at a temperature of 50 to 250 degrees. In the heat treatment zone 400, a process of curing and bonding the solar cell C to which the conductive adhesive is applied and the wire through heat treatment may be performed. In this way, by newly configuring the heat treatment zone 400 curing the bonding with the wire on the solar cell to which the conductive adhesive is applied, a tac time due to wire bonding may be shortened.

According to the present embodiment, a plurality of first protrusions 112 may be formed to come into contact with a plurality of portions of the solar cell C. For example, as illustrated in FIG. 4, four first protrusions 112 may be formed and may be symmetrically disposed in four places around the first suction part 111.

Since the first suction part 111 is disposed at a center constituting a symmetrical point of the four first protrusions 112, the solar cell C may uniformly come into contact with and coupled to the four first protrusions 112 during the suction operation of the first suction part 111.

In this case, the first suction unit 111 may be formed to have a predetermined gap G from the solar cell C, and the first protrusion 112 may be formed to protrude more than the first suction part 111 from the surface of the first flip part 110. The first suction part 111 may suction air through the gap G.

In addition, since the first protrusion 112 symmetrically comes into contact with the surface of the solar cell C, the solar cell C may not be tilted to one side and may uniformly come into contact with and coupled to the four first protrusions 112. In the present embodiment, four first protrusions 112 are formed, but the number and arrangement positions of the first protrusions 112 are not limited thereto and various embodiments may be implemented as long as the number and arrangement positions of the first protrusions 112 are capable of stably flipping the solar cell C.

According to the present embodiment, referring to FIG. 3, the end portion 112a of the first protrusion 112 may be provided with a material having a predetermined friction force without damaging the solar cell C when coming into contact with the solar cell C. For example, the end portion 112a may include a resin material such as urethane resin. Accordingly, when the end portion 112a comes into contact with the surface of the solar cell C, the defect rate may be improved by preventing the peeling, tearing (e.g., perovskite tearing and the like), etc. of the surface material of the solar cell C. In addition, since the end portion 112a has a predetermined frictional force with the solar cell C, when the solar cell C is transferred, the solar cell C may be transferred to a set position.

Referring to FIG. 4, when the first flip part 110 adsorbs and fixes the solar cell C, a center portion CC of the first suction part 111 may be adsorbed and fixed at a position consistent with the center of gravity CC of the solar cell C. Accordingly, the positions of the first suction part 111 and the four first protrusions 112 of the first flip part 110 may be symmetrically disposed around the center of gravity CC of the solar cell C, so that the first flip part 110 may stably adsorb and flip the solar cell C.

According to the present embodiment, at least one first flip part 110 may be formed. For example, the first flip part 110 is formed at an angle of 180 degrees on both sides with the main body part 120 as the center, and as the main body part 120 rotates, the two first flip parts 110 may alternately flip the solar cell C.

In this way, through a structure in which the two first flip parts 100 are disposed, the application process of the solar cell C may proceed faster, thereby improving productivity.

Hereinafter, with reference to FIG. 7, a solar cell manufacturing method according to one embodiment of the present invention will be described. For content not illustrated in FIG. 7, reference may be made to FIGS. 1 to 6.

FIG. 7 is a flowchart illustrating a solar cell manufacturing method according to one embodiment of the present invention.

Referring to FIG. 7, the solar cell manufacturing method according to one embodiment of the present invention includes an operation of transferring a solar cell to a place where a first dispenser is located (S100), an operation of applying a conductive adhesive to a first surface of the solar cell through the first dispenser (S200), an operation of transferring the solar cell with the first surface to which the conductive adhesive is applied to a flip part through a first conveyor (S300), an operation of flipping the solar cell by the flip part (S400), an operation of seating the flipped solar cell on a shuttle (S500), an operation of transferring the solar cell to a place where a second dispenser is located by the shuttle (S600), and an operation of applying a conductive adhesive to a second surface of the solar cell by the second dispenser (S700).

In this case, the method may further include an operation of performing a wire bonding process by moving the solar cell to which the conductive adhesive is applied on both the first and second surfaces to a heat treatment zone (S800).

Furthermore, the operation of seating the flipped solar cell on the shuttle (S500) includes an operation of moving the shuttle upward (S510), an operation of seating the solar cell C on the shuttle (S520), and an operation of moving the shuttle downward (S530).

Through this, it is possible to secure uniformity of quality in the process of applying conductive adhesives to solar cells, shorten a tac time, and secure productivity through optimization.

The present invention has been described with reference to the embodiments illustrated in the drawings as described above, but these are merely examples. Those of ordinary skill in the art will fully understand that various modifications and equivalent other embodiments are possible from the embodiments. Accordingly, the true technical protection scope of the present invention should be determined based on the appended claims.

The specific technical content described in the embodiments is an example and does not limit the technical scope of the embodiment. In order to describe the description of the invention concisely and clearly, descriptions of a general technique and configuration in the related art may be omitted. Additionally, the connection or absence of connection of lines between the components illustrated in the drawing exemplifies functional connections and/or physical or circuit connections and may be expressed as a variety of alternative or additional functional connections, physical connections, or circuit connections in real devices. In addition, when there is no specific mention such as "essential," "important," or the like, it may not be an essential component for the application of the present invention.

The term "the" or similar designators described in the description and claims of the present invention may refer to both singular and plural, unless specifically limited. In addition, when a range is described in an embodiment, it is considered that the present invention includes an invention to which an individual value belonging to the range is applied (unless otherwise described), and it is the same as describing each individual value constituting the range in the description of the invention. In addition, when there is no explicit description or contradiction regarding the operations constituting the method according to the embodiment, the operations may be performed in any appropriate order. The embodiments are not necessarily limited according to the described order of operations. The use of any examples or exemplary terms (e.g., etc.) in the embodiments is simply for describing the embodiments in detail and does not limit the scope of the embodiments by virtue of such examples or exemplary terms, unless otherwise limited by the claims. In addition, a person skilled in the art will appreciate that various modifications, combinations, and changes can be made according to design conditions and factors within the scope of the appended claims or their equivalents.

## Claims

1. A solar cell manufacturing apparatus comprising:
a first dispenser configured to apply a conductive adhesive to a first surface of a solar cell;
a flip part configured to flip the solar cell;
a second dispenser configured to apply a conductive adhesive to a second surface of the solar cell;
a first conveyor configured to transfer the solar cell with the first surface to which the conductive adhesive is applied through the first dispenser to a place where the flip part is located; and
a shuttle configured to transfer the solar cell flipped through the flip part to a place where the second dispenser is located.

2. The solar cell manufacturing apparatus of claim 1, wherein the flip part includes:
a rotating main body part; and
a first flip part coupled to one side of the main body part,
wherein the first flip part includes:
a first suction part configured to suction the solar cell in a direction in which the flip part is located; and
a first protrusion having an end portion protruding to come into contact with the solar cell.

3. The solar cell manufacturing apparatus of claim 2, wherein the first flip part is coupled to the second surface of the solar cell through the first protrusion and the first suction part, and
when the main body part is rotated, the first flip part is released from the coupling with the solar cell and the solar cell is seated on the shuttle.

4. The solar cell manufacturing apparatus of claim 1, wherein the shuttle includes a shuttle protrusion formed to protrude upward so that the solar cell is seated.

5. The solar cell manufacturing apparatus of claim 4, wherein the shuttle includes first and second portions on which both sides and a center side of the solar cell are respectively seated, and
the shuttle protrusions are disposed in the first and second portions, respectively.

6. The solar cell manufacturing apparatus of claim 1, further comprising a heat treatment zone in which the solar cell passing through the second dispenser is bonded to a wire.

7. The solar cell manufacturing apparatus of claim 2, wherein a plurality of first protrusions are formed to come into contact with a plurality of portions of the solar cell.

8. The solar cell manufacturing apparatus of claim 1, wherein the first dispenser applies the conductive adhesive to the first surface of the solar cell disposed below the first dispenser, and
the second dispenser applies the conductive adhesive to the second surface of the solar cell disposed below the second dispenser.

9. The solar cell manufacturing apparatus of claim 2, wherein at least one first flip part is formed.

10. The solar cell manufacturing apparatus of claim 9, wherein the first flip parts are formed on both sides with the main body part as the center, and
as the main body part rotates, the two first flip parts alternately flip the solar cell.

11. A solar cell manufacturing method comprising:
an operation of transferring a solar cell to a place where a first dispenser is located;
an operation of applying a conductive adhesive to a first surface of the solar cell through the first dispenser;
an operation of transferring the solar cell including the first surface to which the conductive adhesive is applied to a flip part through a first conveyor;
an operation of flipping, by the flip part, the solar cell;
an operation of seating the flipped solar cell on a shuttle;
an operation of transferring, by the shuttle, the solar cell to a place where a second dispenser is located; and
an operation of applying, by the second dispenser, a conductive adhesive to a second surface of the solar cell.

12. The solar cell manufacturing method of claim 11, wherein the operation of seating the flipped solar cell on the shuttle includes:
an operation of moving the shuttle upward;
an operation of seating the solar cell on the shuttle; and
an operation of moving the shuttle downward.

13. The solar cell manufacturing method of claim 11, further comprising an operation of performing a wire bonding process by moving the solar cell to which the conductive adhesive is applied on both the first and second surfaces to a heat treatment zone.
